# EUROPEAN PATENT APPLICATION

(11) **EP 1 830 411 A1**
(43) Date of publication of application: **05.09.2007**
(21) Application number: 05820379.5
(22) Date of filing: 22.12.2005
(51) Int. Cl.: H01L 31/032, H01L 31/048

(54) **CIS BASED THIN FILM SOLAR CELL MODULE, METHOD FOR PRODUCING THE SAME, AND METHOD FOR SEPARATING SOLAR CELL MODULE**

(30) Priority: 22.12.2004 JP 2004370332
(71) Applicant: Showa Shell Sekiyu Kabushiki Kaisha, Minato-ku Tokyo 1358074 (JP)
(72) Inventor: KUSHIYA, Katsumi, Minato-ku, Tokyo 135-8074 (JP); TANAKA, Manabu, Minato-ku, Tokyo 135-8074 (JP)
(74) Representative: HOFFMANN EITLE
(86) International application number: PCT/JP2005/023622
(87) International publication number: WO 2006/068234

(57) **Abstract**

Constituent materials of a CIS type thin-film photovoltaic module are made separable and recyclable without reducing output characteristics and durability.

A thin-film photovoltaic module 1 having a substrate structure comprising a CIS type thin-film solar cell device 2 and a cover glass 4 bonded to the light incidence side of the device 2 with a thermally crosslinked EVA resin or the like 3 as an adhesive is made to include a non-adhesive plastic (e.g., polyester) resin 6 sandwiched between the solar cell device 2 and the EVA resin 3. Thus, the constituent materials are separable. Through later simple separation steps, the constituent materials are separated and recovered.

## Description

### TECHNICAL FIELD

The present invention relates to a CIS type thin-film photovoltaic module which is recyclable, a process for producing the photovoltaic module, and a method of separating the module.

### BACKGROUND ART

Photovoltaic modules are used outdoors and are hence required to have a long life and durability which enables the modules to withstand various environments in the terrestrial application on the earth. Because of this, a general structure currently in use is one in which a thermally crosslinked ethylene/vinyl acetate (hereinafter abbreviated to EVA) resin or the like is used as a sealing material or adhesive for a photovoltaic module to bond a cover glass (front glass) or back sheet (back material). In crystalline-silicon photovoltaic modules, which are mainly employed at present, the crystalline-silicon solar cells, which are most expensive, are encapsulated in a thermally crosslinked EVA resin. From the standpoint of recycling the constituent materials, attempts are being made to separate/disassemble a photovoltaic module and to take out constituent materials from the module. Among the crystalline-silicon solar cell modulus, a photovoltaic module of the recyclable type (see, for example, patent document 1) is known.

Patent Document 1: JP-A-2003-142720

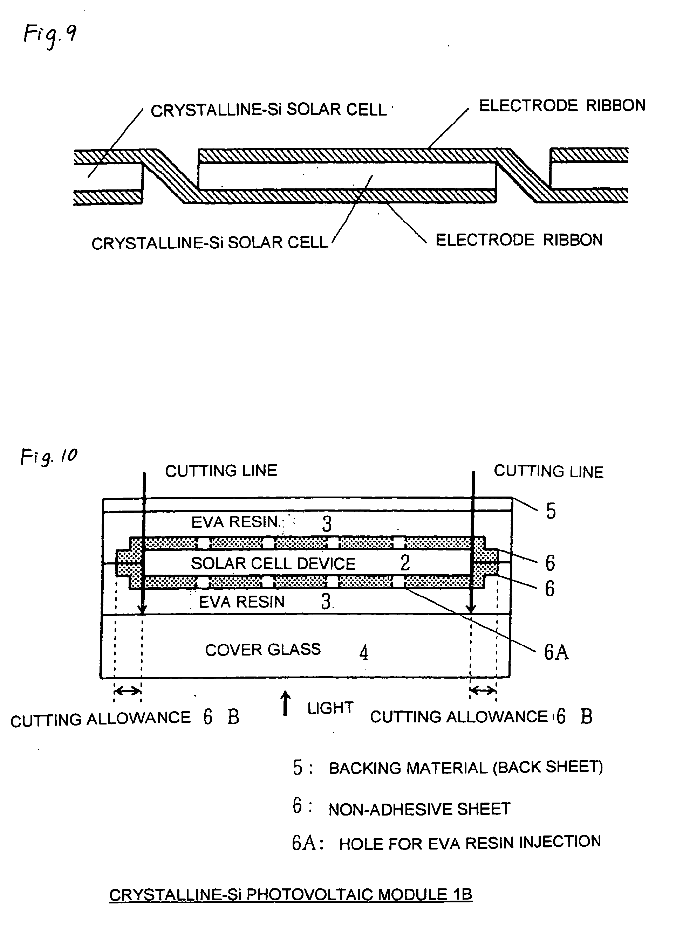

As shown in Fig. 8, the crystalline-silicon photovoltaic module 1A described in patent document 1 has a structure comprising a front glass 4/EVA resin (sealing material) 3/non-adhesive sheet 6/crystalline-silicon solar cell 2/non-adhesive sheet 6/EVA resin (sealing material) 3/back material 5 in this order from the incident sunlight side. This crystalline-silicon photovoltaic module 1A has a structure in which each of the sunlight incidence side and the opposite side (back side) of the crystalline-silicon solar cell 2 is bonded to an EVA resin (sealing material) 3 through a non-adhesive sheet 6 to encapsulate the cells, i.e., a structure in which a pair of non-adhesive sheets 6 is used. The crystalline-silicon solar cell 2 to be encapsulated usually comprises a structure (strings) made up of solar cells whose front and back sides are alternately connected with electrode ribbons, as shown in Fig. 9, so as to have given output characteristics. In the case of such a crystalline-silicon solar cell 2 composed of cells, holes 6A for EVA resin injection which extend from one to the other side are formed in non-adhesive sheets 6 in order to fix the solar cell 2 including the electrode materials. An EVA resin enters the holes 6A and the EVA resin partly bonds the sheets 6 to the periphery of the cells on the front and back sides thereof. Thus, the crystalline-silicon solar cell 2 is held and fixed. The non-adhesive sheets 6 are larger than the part occupied by the solar cells, and the areas protruding from the cell part are cutting allowances 6B.

In recycling a crystalline-silicon solar cell device 2 having the structure described above, the following method has been employed for separation/cutting. As shown in Fig. 10 (sectional area), the module is cut from the back side along the cutting lines to cut out the cutting allowances 6B. The two non-adhesive sheets 6 are stripped off, whereby the crystalline-silicon solar cells 2 sandwiched between the sheets and connected with electrode ribbons are taken out.

The crystalline-silicon photovoltaic module of the recyclable type described above necessitates a step for fixing each of the cells. There has been a problem that since the gap between the cells cannot be made zero, the degree of cell packing cannot be improved and this results in an output loss.

As described above, the structure of the crystalline-silicon photovoltaic module of the recyclable type and the process for producing the photovoltaic module have had a problem that since use of two non-adhesive sheets to be disposed on the upper and lower sides and the formation of through-holes in each non-adhesive sheet are necessary, the number of production steps is more increased and the process is complicated.

### DISCLOSURE OF THE INVENTION

### PROBLEMS THAT THE INVENTION IS TO SOLVE

The invention eliminates the problems described above. An object of the invention is to produce an integrated type thin-film photovoltaic module fabricated on a glass or another substrate having a large size or large area unlike the crystalline-silicon photovoltaic module, in particular, to produce a CIS type thin-film photovoltaic module having a structure facilitating recycling by a simple process through a small number of steps without reducing the output characteristics and durability of the CIS type thin-film solar cells. Another object is to separate the CIS type thin-film photovoltaic module of that structure into individual constituent materials by a simple separation method and thereby enable the constituent materials to be separately recovered.

### MEANS FOR SOLVING THE PROBLEMS

(1) The invention, which eliminates the problems described above, provides a CIS type thin-film photovoltaic module which comprises a glass substrate, a CIS type thin-film solar cell device comprising superposed thin layers each formed on the glass substrate, and a cover glass bonded to the light incidence side of the solar cell device with a thermally crosslinked resin, e.g., an ethylenevinyl acetate (EVA) resin, as an adhesive, the CIS type thin-film photovoltaic module having a structure facilitating recycling which includes a non-adhesive plastic resin sandwiched between the CIS type thin-film solar cell device and the resin, e.g., EVA resin.

(2) The invention provides a process for producing a CIS type thin-film photovoltaic module, comprising a glass substrate, a CIS type thin-film solar cell device comprising superposed thin layers each formed on the glass substrate, a cover glass bonded to the light incidence side of the solar cell device using a thermally crosslinkable resin, e.g., an EVA resin, as an adhesive, and a back sheet bonded to the back side of the glass substrate, i.e., the side opposite to the light incidence side, with a thermally crosslinked resin, e.g., an EVA resin, as an adhesive, wherein heating is conducted while keeping a non-adhesive plastic resin being sandwiched between the CIS type thin-film solar cell device and the resin, e.g., EVA resin, to bond the cover glass to the light incidence side of the CIS type thin-film solar cell device with the resin, e.g., EVA resin, in a crosslinked state.

(3) The invention provides the process for producing a CIS type thin-film photovoltaic module according to (2) above, which comprises sandwiching a sheet made of a non-adhesive plastic having high transparency between the CIS type thin-film solar cell device and a resin, e.g., an EVA resin, placing a cover glass on the resin, e.g., EVA resin, and then heating the whole resultant assemblage with a laminator or the like to crosslink the resin, e.g., EVA resin, and fix the non-adhesive sheet underlying the resin.

(4) The invention provides the CIS type thin-film photovoltaic module according to (1) above or the process for producing a CIS type thin-film photovoltaic module according to (2) or (3) above, wherein the non-adhesive plastic resin is one which has high transparency and light-transmitting properties, has resistance to heating at 100-200°C, and is not discolored by ultraviolet.

(5) The invention provides the CIS type thin-film photovoltaic module as described under (1) above or the process for CIS type thin-film photovoltaic module production as described under (2) or (3) above, wherein the non-adhesive plastic resin is in the form of a large-area sheet having a thickness of up to several tens of micrometers and is made of any one of polycarbonate resins, ETFE resins, polyester resins, polypropylene resins, and the like, desirably made of a polyester resin.

(6) The invention provides a method of CIS type thin-film photovoltaic module separation for separating/recovering constituent materials of the CIS type thin-film photovoltaic module according to (1) above or of a CIS type thin-film photovoltaic module produced by the process for producing a CIS type thin-film photovoltaic module production according to any one of (2) to (5) above, wherein the method of CIS type thin-film photovoltaic module separation comprising separation steps I to V:
the separation step I being a step in which the CIS type thin-film photovoltaic module comprising a cover glass, a resin, e.g., an EVA resin, a non-adhesive sheet, a CIS type thin-film solar cell device, a glass substrate, a resin, e.g., an EVA resin, and a back sheet which have been superposed in this order from the light incidence side is separated into: a first multilayer structure comprising the cover glass and the resin, e.g., EVA resin; the non-adhesive sheet; and a second multilayer structure comprising the CIS type thin-film solar cell device, the glass substrate, the resin, e.g., EVA resin, and the back sheet,
the separation step II being a step in which the CIS type thin-film solar cell device is removed from the second multilayer structure separated in the separation step I (comprising the CIS type thin-film solar cell device, the glass substrate, the resin, e.g., EVA resin, and the back sheet) to thereby separate the second multilayer structure into the CIS type thin-film solar cell device and a third multilayer structure comprising the glass substrate, the resin, e.g., EVA resin, and the back sheet,
the separation step III being a step in which the resin, e.g., EVA resin, is removed from the first multilayer structure separated in the separation step I (comprising the cover glass and the resin, e.g., EVA resin) to thereby separate the first multilayer structure into the cover glass and the resin, e.g., EVA resin,
the separation step IV being a step in which the back sheet is removed from the third multilayer structure separated in the separation step II (comprising the glass substrate, the resin, e.g., EVA resin, and the back sheet) to thereby separate the third multilayer structure into the back sheet and a fourth multilayer structure comprising the glass substrate and the resin, e.g., EVA resin, and
the separation step V being a step in which the resin, e.g., EVA resin, is removed from the fourth multilayer structure separated in the separation step IV (comprising the glass substrate and the resin, e.g., EVA resin) to thereby separate the fourth multilayer structure into the resin, e.g., EVA resin, and the glass substrate.

(7) The invention provides themethodof CIS type thin-film photovoltaic module separation according to (6) above, wherein the separation step I comprises cutting that part of the CIS type thin-film photovoltaic module which corresponds to a peripheral part for the glass substrate with a cutting tool, e.g., a knife or cutter, from the back side to separate the module into the first multilayer structure (comprising the cover glass and the resin, e.g., EVA resin), which adjoins one side of the non-adhesive plastic resin, and the second multilayer structure (comprising the CIS type thin-film solar cell device, the glass substrate, the resin, e.g., EVA resin, and the back sheet).

(8) The inventionprovides the method of CIS type thin-film photovoltaic module separation according to (6) above, wherein the separation step II comprises removing the CIS type thin-film solar cell device from the second multilayer structure (comprising the CIS type thin-film solar cell device, the glass substrate, the resin, e.g., EVA resin, and the back sheet) by a dry mechanical method, e.g., sandblasting, scraping with a metallic blade, or a combination of these, to separate the second multilayer structure into the CIS type thin-film solar cell device and the third multilayer structure (comprising the glass substrate, the resin, e.g., EVA resin, and the back sheet).

(9) The inventionprovides themethodof CIS type thin-film photovoltaic module separation according to (6) above, wherein the separation step III comprises removing the resin, e.g., EVA resin, from the first multilayer structure (comprising the cover glass and the resin, e. g., EVAresin) by a drymechanical method of removal, e.g., sandblasting, or a wet chemical method of removal, e.g., boiling, high-temperature steam blowing, or immersion in an acid, to separate the first multilayer structure into the resin, e.g., EVA resin, and the cover glass.

(10) The invention provides the method of CIS type thin-film photovoltaic module separation according to (6) above, wherein the separation step IV comprises removing the back sheet from the third multilayer structure (comprising the glass substrate, the resin, e.g., EVA resin, and the back sheet) by mechanical stripping to separate the third multilayer structure into the back sheet and the fourth multilayer structure (comprising the glass substrate and the resin, e.g., EVA resin).

(11) The invention provides the method of CIS type thin-filmphotovoltaicmodule separation according to (6) above, wherein the separation step V comprises removing the resin, e.g., EVAresin, from the fourth multilayer structure (comprising the glass substrate and the resin, e.g., EVA resin) by a dry mechanical method, e.g., sandblasting, scraping with a metallic blade, or a combination of these, to separate the fourth multilayer structure into the resin, e.g., EVA resin, and the glass substrate.

### ADVANTAGES OF THE INVENTION

According to the invention, a CIS type thin-film photovoltaic module having a structure facilitating recycling can be produced by a simple process through a small number of steps without reducing the output characteristics and durability of the solar cells of the CIS type thin-film photovoltaic module, by employing a structure in which a non-adhesive plastic sheet is sandwiched between the upper light incidence side of the solar cell device and the resin, e.g., an EVA resin, as an adhesive. Furthermore, the CIS type thin-filmphotovoltaicmodule of that structure can be separated into individual constituent materials by a simple separation method and the constituentmaterials canbe separately recovered.

### BEST MODE FOR CARRYING OUT THE INVENTION

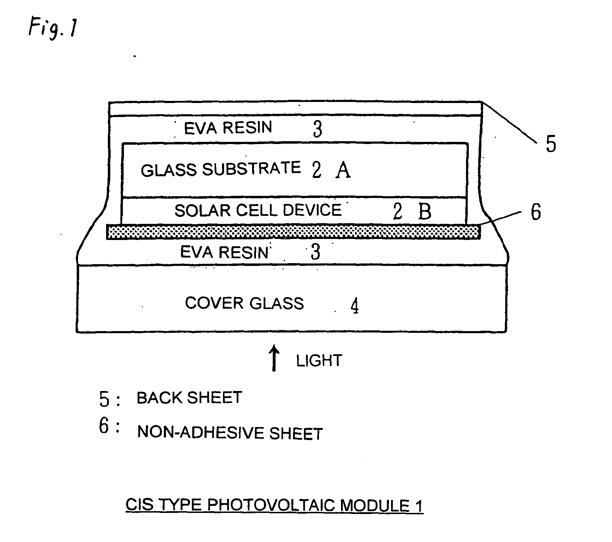

The invention provides a CIS type thin-film photovoltaic module which can be easily recycled, a process for producing the photovoltaic module, and a method of separating the module. As shown in Fig. 1, the CIS type thin-film photovoltaic module 1 has a structure which comprises a glass substrate 2A, a CIS type thin-film solar cell device 1 comprising superposed thin layers each formed on the glass substrate 2A, a cover glass 4 bonded to the light incidence side of the solar cell device 1 with a thermally crosslinked ethylene/vinyl acetate (EVA) resin (or a resin other than the EVA resin) 3 as an adhesive, and a back sheet 5 bonded to the back side of the glass substrate 2A, i.e., the side opposite to the light incidence side, with a thermally crosslinked EVA resin 3 as an adhesive, and which further includes a non-adhesive plastic resin 6 sandwiched between the CIS type thin-film solar cell device 2 and the EVA resin 3. Due to this structure, the constituent materials can be easily separated and easily recycled.

In order for a CIS type thin-film photovoltaic module to have the structure which facilitates recycling, it is produced by the following process.
Use is made of a process for producing a CIS type thin-film photovoltaic module 1 having a structure which comprises a glass substrate 2A, a CIS type thin-film solar cell device 2B comprising superposed thin layers formed on the glass substrate 2A, a cover glass 4 bonded to the light incidence side of the solar cell device 2B with a thermally crosslinked EVA resin 3 as an adhesive, and a back sheet 5 bonded to the back side of the glass substrate 2A, i.e., the side opposite to the light incidence side, with a thermally crosslinked EVA resin 3 as an adhesive, wherein heating is conducted while keeping a non-adhesive plastic resin 6 being sandwiched between the CIS type thin-film solar cell device 2B and the EVA resin 3 to bond the cover glass 4 to the light incidence side of the CIS type thin-film solar cell device 2B with the EVA resin 3 in a crosslinked state and thereby produce the CIS type thin-film photovoltaic module.

More specifically, a non-adhesive plastic resin 6, desirably a polyester resin, is sandwiched between the CIS type thin-film solar cell device 2B and the EVA resin 3, and a cover glass 4 is placed on the EVA resin 3. Thereafter, the whole resultant assemblage is heated in a laminator to crosslink the EVA resin 3. The cover glass 4 is bonded to the EVA resin 3 by the bonding function of the resin.

**[Table 1]**

| Results of selection of non-contact resins | | | |
|---|---|---|---|
| Non-contact resin | Cost-estimated [yen/m²] | Output after module fabrication [%] | Results of moisture resistance test |
| EVA without non-contact resin | 533 | 100 | No problem. |
| Poly-carbonate (& EVA) | unsuitable: 935 | unsuitable: 92 | unsuitable: Rumpling occurred in periphery of substrate. Bubbles generated. |
| ETFT (& EVA) | unsuitable: 690 | 99 | unsuitable: Rumpling occurred in periphery of substrate. Bubbles generated. |
| Polyester (& EVA) | 355 | 99 | No problem. (It is necessary to inhibit rumpling in periphery of substrate.) |
| Polypropylene (& EVA) | 177 | unsuitable: 91 | No problem. (It is necessary to inhibit rumpling in periphery of substrate.) |
| PTCFE (& EVA) | unsuitable: 4503 | unsuitable: 96 | unsuitable: Rumpling occurred partly (insufficient heat resistance). Bubbles generated. |
| Moisture resistance test: 1,000-hour (42-day) storage in a dark environment at temperature of 85°C and relative humidity of 85% | | | |

The reasons why a polyester resin is desirable as the non-adhesive plastic resin 6 are as follows. As shown in the experimental results given in Table 1, the following were found. When the output of the CIS type thin-film photovoltaic module fabricated with an EVA resin (without using a non-adhesive plastic resin) is taken as 100%, the module fabricated with the EVA resin using a polyester resin as a non-adhesive plastic resin sandwiched shows a smallest decrease in output of 1% among the CIS type thin-film photovoltaic modules fabricated with the EVA resin using non-adhesive plastic resins sandwiched.
In addition, this module including a polyester resin is inexpensive and poses no problem concerning the results of the high-humidity test (durability).

The non-adhesive plastic resin 6 desirably is one which has high transparency and light-transmitting properties, has resistance to heating at 100-200°C, and is not discolored by ultraviolet.

The non-adhesive plastic resin 6 may be (supplied) in the form of a large-area sheet having a thickness of up to several tens of micrometers and made of any one of polycarbonate resins, ETFE resins, polyester resins, polypropylene resins, and the like, desirably a polyester resin.

The method of separating (recycling) a CIS type thin-film photovoltaic module 1 having the structure facilitating recycling is explained below.
The method of the invention for separating (recycling) a CIS type thin-film photovoltaic module 1 is one for separating/recovering constituent materials of a CIS type thin-film photovoltaic module having the structure described above or of a CIS type thin-film photovoltaic module produced by the process for CIS type thin-film photovoltaic module production described above, and comprises the following separation step I to separation step V.

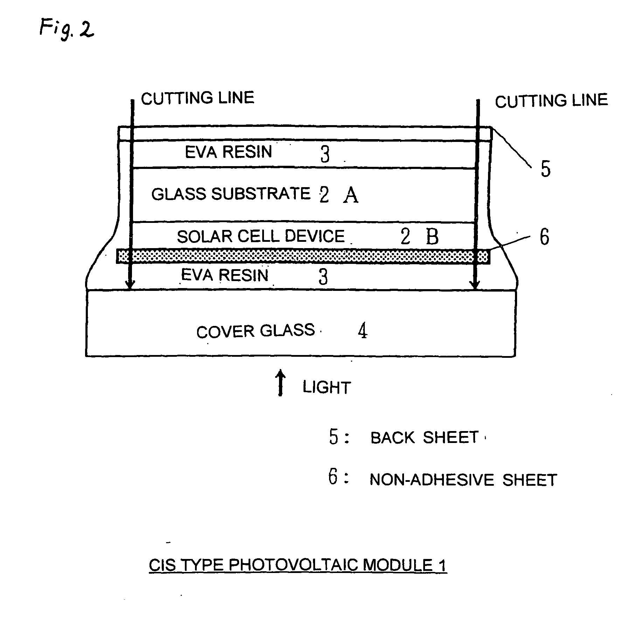

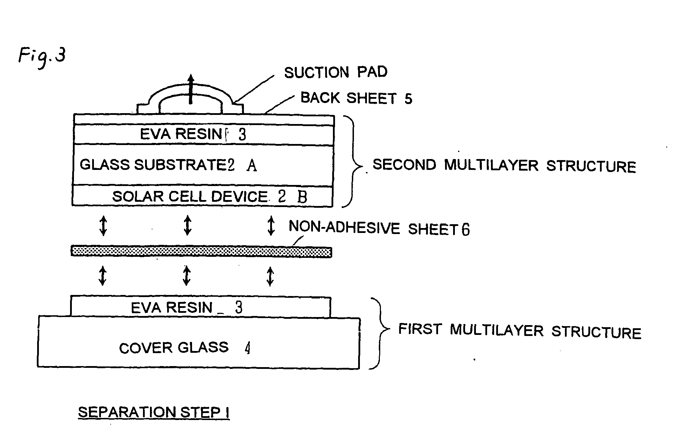

In separation step I, that part of the CIS type thin-film photovoltaic module 1 which corresponds to a peripheral part for the glass substrate 2A is cut with a cutting tool, e.g., a knife or cutter, from the back side, i.e., from the back sheet 5 side, as shown in Fig. 2. Thereafter, the upper side (back sheet) of this CIS type thin-film photovoltaic module 1, which comprises a cover glass 4, EVA resin 3, non-adhesive sheet 6, CIS type thin-film solar cell device 2B, glass substrate 2A, EVA resin 3, and back sheet 5 superposed in this order from the light incidence side, is lifted up with a vacuum holding device, e.g., a vacuum holding pad, to thereby separate the module 1 into: a first multilayer structure comprising the cover glass 4 and the EVA resin 3; the non-adhesive sheet 6; and a second multilayer structure comprising the CIS type thin-film solar cell device 2B, glass substrate 2A, EVA resin 3, and back sheet 5, as shown in Fig. 3.

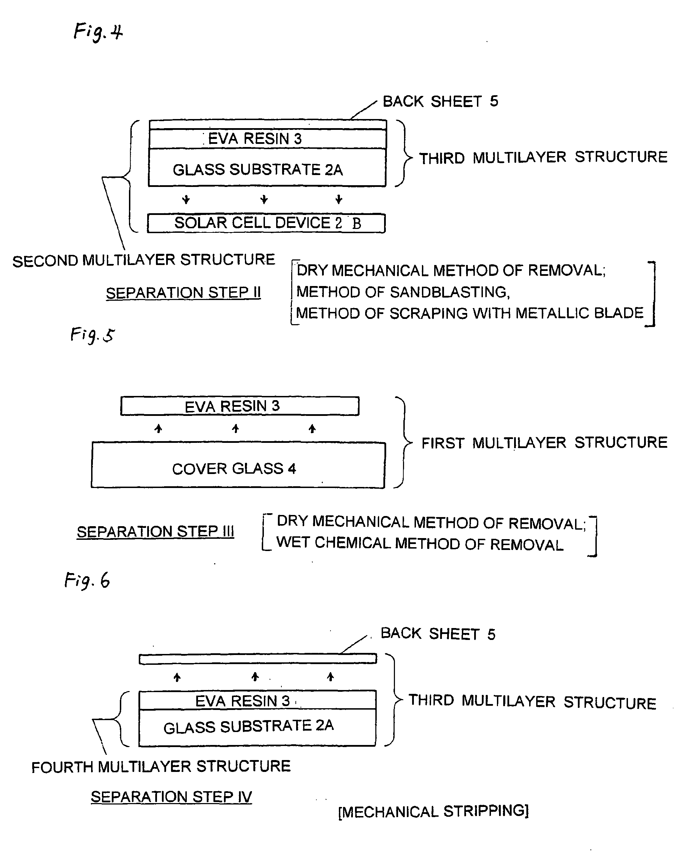

In separation step II, the CIS type thin-film solar cell device 2B is removed from the second multilayer structure separated in separation step I (comprising the CIS type thin-film solar cell device 2B, glass substrate 2A, EVA resin 3, and back sheet 5) by a dry mechanical method, e.g., sandblasting, scraping with a metallic blade, or a combination of these, to separate the second multilayer structure into the CIS type thin-film solar cell device 2B and a third multilayer structure comprising the glass substrate 2A, EVA resin 3, and back sheet 5, as shown in Fig. 4.

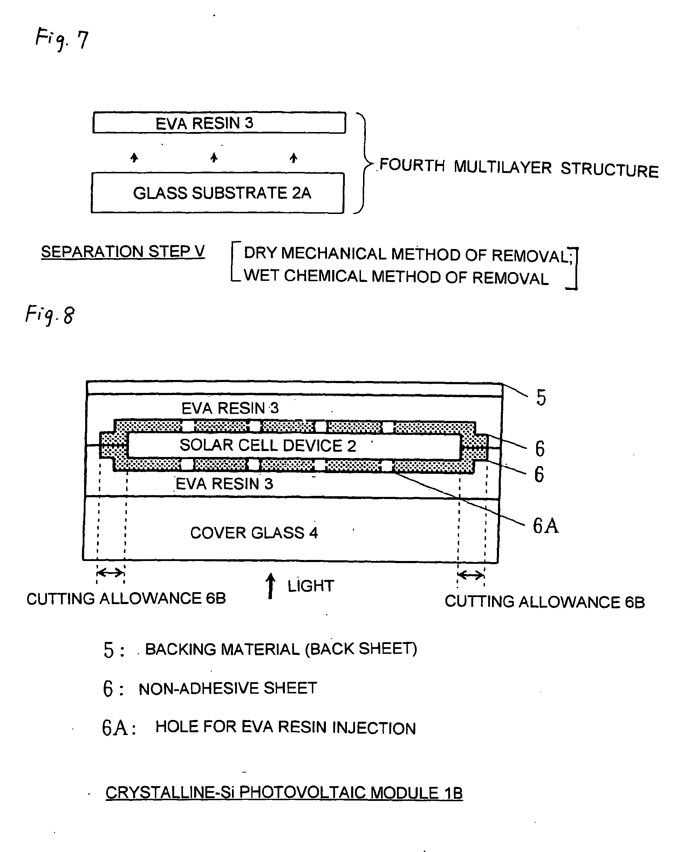

In separation step III, the EVA resin 3 is removed from the first multilayer structure separated in separation step I (comprising the cover glass 4 and the EVA resin 3) by a dry mechanical method of removal, e.g., sandblasting, or a wet chemical method of removal, e.g., boiling, high-temperature steam blowing, or immersion in an acid, to separate the first multilayer structure into the cover glass 4 and the EVA resin 3, as shown in Fig. 5.

In separation step IV, the back sheet 5 is removed from the third multilayer structure separated in separation step II (comprising the glass substrate 2A, EVA resin 3, and back sheet 5) by mechanical stripping to separate the third multilayer structure into the back sheet 5 and a fourthmultilayer structure comprising the glass substrate 2A and the EVA resin 3, as shown in Fig. 6.

In separation step V, the EVA resin 3 is removed from the fourth multilayer structure separated in separation step IV (comprising the glass substrate 2A and the EVA resin 3) by a dry mechanical method, e.g., sandblasting, scraping with a metallic blade, or a combination of these, to separate the fourth multilayer structure into the EVA resin 3 and the glass substrate 2A, as shown in Fig. 7.

As described above, the CIS type thin-film photovoltaic module 1 of the invention, which is easy to recycle, has a structure in which a non-adhesive sheet (film) 6 comprising, e.g., a polyester resin has been sandwiched between the solar cell device 2B and EVA resin 3 which are constituent materials of the module 1. The photovoltaic module 1 having this structure is subjected to a separation process comprising the separation step I to separation step V. Thus, the CIS type thin-film photovoltaic module 1 can be easily separated into individual constituent materials thereof, i.e., the glass substrate 2A, solar cell device 2B, EVA resin 3, cover glass (front glass) 4, back sheet (back material) 5, and non-adhesive sheet (film) 6, and these constituent materials can be separately recovered as resources.

Of those constituent materials, the cover glass (front glass) 4 is expensive, and the glass substrate 2A and the solar cell device 2B are expensive and contain rare metals such as gallium and indiumbecause the solar cells are of the CIS thin-film type. Consequently, such valuable substances and rare resources can be effectively utilized.

### BRIEF DESCRIPTION OF THE DRAWINGS

[Fig. 1] Fig. 1 is a view (sectional view) showing the structure of a CIS type thin-film photovoltaic module 1 of the invention.
[Fig. 2] Fig. 2 is a view (sectional view) showing how the CIS type thin-film photovoltaic module 1 of the invention is cut from the upper side (separation step I).
[Fig. 3] Fig. 3 is a view (sectional view) showing separation step I in a separation method of the invention for separating a CIS type thin-film photovoltaic module 1.
[Fig. 4] Fig. 4 is a view (sectional view) showing separation step II in the separation method of the invention for separating a CIS type thin-film photovoltaic module 1.
[Fig. 5] Fig. 5 is a view (sectional view) showing separation step III in the separation method of the invention for separating a CIS type thin-film photovoltaic module 1.
[Fig. 6] Fig. 6 is a view (sectional view) showing separation step IV in the separation method of the invention for separating a CIS type thin-film photovoltaic module 1.
[Fig. 7] Fig. 7 is a view (sectional view) showing separation step V in the separation method of the invention for separating a CIS type thin-film photovoltaic module 1.
[Fig. 8] Fig. 8 is a view (sectional view) showing the structure of a related-art crystalline-silicon photovoltaic module 1B of the recyclable type.
[Fig. 9] Fig. 9 is a view (sectional view) showing the string structure of solar cells in the related-art crystalline-silicon photovoltaic module 1 of the recyclable type.
[Fig. 10] Fig. 10 is a view (sectional view) showing cutting-out positions (cutting positions) in the related-art crystalline-silicon photovoltaic module 1 of the recyclable type.

### DESCRIPTION OF REFERENCE NUMERALS AND SIGNS

- 1: CIS type thin-film photovoltaic module
- 1A: crystalline type photovoltaic module
- 2: CIS type thin-film solar cell device
- 2A: glass substrate
- 2B: CIS type thin-film solar cell device
- 3: EVA resin (sealing material)
- 4: cover glass
- 5: back sheet
- 6: non-adhesive sheet (film)
- 6A: hole for EVA resin injection
- 6B: cutting allowance

## Claims

1. A CIS type thin-film photovoltaic module which comprises a glass substrate, a CIS type thin-film solar cell device comprising superposed thin layers each formed on the glass substrate, and a cover glass bonded to the light incidence side of the solar cell device with a thermally crosslinked resin, e.g., an ethylene/vinyl acetate (EVA) resin, as an adhesive,
wherein the module has a structure facilitating recycling which includes a non-adhesive plastic resin sandwiched between the CIS type thin-film solar cell device and the resin, e.g., EVA resin.

2. A process for producing a CIS type thin-film photovoltaic module, comprising a glass substrate, a CIS type thin-film solar cell device comprising superposed thin layers each formed on the glass substrate, a cover glass bonded to the light incidence side of the solar cell device using a thermally crosslinkable resin, e.g., an EVA resin, as an adhesive, and a back sheet bonded to the back side of the glass substrate, i.e., the side opposite to the light incidence side, with a thermally crosslinked resin, e. g., an EVA resin, as an adhesive,
wherein heating is conducted while keeping a non-adhesive plastic resin being sandwiched between the CIS type thin-film solar cell device and the resin, e.g., EVA resin, to bond the cover glass to the light incidence side of the CIS type thin-film solar cell device with the resin, e.g., EVAresin, in a cross linked state.

3. The process for producing a CIS type thin-film photovoltaic module according to claim 2, **characterized by** sandwiching a sheet made of a non-adhesive plastic having high transparency between the CIS type thin-film solar cell device and a resin, e.g., an EVA resin, placing a cover glass on the resin, e.g., EVA resin, and then heating the whole resultant assemblage with a laminator or the like to crosslink the resin, e.g., EVA resin, and fix the non-adhesive sheet underlying the resin.

4. The CIS type thin-film photovoltaic module according to claim 1 or the process for producing a CIS type thin-film photovoltaic module according to claim 2 or 3, wherein the non-adhesive plastic resin is one which has high transparency and light-transmitting properties, has resistance to heating at 100-200°C, and is not discolored by ultraviolet.

5. The CIS type thin-film photovoltaic module according to claim 1 or the process for producing a CIS type thin-film photovoltaic module according to claim 2 or 3, wherein the non-adhesive plastic resin is in the form of a large-area sheet having a thickness of up to several tens of micrometers and is made of any one of polycarbonate resins, ETFE resins, polyester resins, polypropylene resins, and the like, desirably made of a polyester resin.

6. A method of CIS type thin-film photovoltaic module separation for separating/recovering constituent materials of the CIS type thin-film photovoltaic module according to claim 1 or of a CIS type thin-film photovoltaic module produced by the process for producing a CIS type thin-film photovoltaic module production according to any one of claims 2 to 5, **characterized by** comprising separation steps I to V:
the separation step I being a step in which the CIS type thin-film photovoltaic module comprising a cover glass, a resin, e.g., an EVA resin, a non-adhesive sheet, a CIS type thin-film solar cell device, a glass substrate, a resin, e.g., an EVA resin, and a back sheet which have been superposed in this order from the light incidence side is separated into: a first multilayer structure comprising the cover glass and the resin, e.g., EVA resin; the non-adhesive sheet; and a second multilayer structure comprising the CIS type thin-film solar cell device, the glass substrate, the resin, e.g., EVA resin, and the back sheet,
the separation step II being a step in which the CIS type thin-film solar cell device is removed from the second multilayer structure separated in the separation step I (comprising the CIS type thin-film solar cell device, the glass substrate, the resin, e.g., EVA resin, and the back sheet) to thereby separate the second multilayer structure into the CIS type thin-film solar cell device and a third multilayer structure comprising the glass substrate, the resin, e.g., EVA resin, and the back sheet,
the separation step III being a step in which the resin, e.g., EVA resin, is removed from the first multilayer structure separated in the separation step I (comprising the cover glass and the resin, e.g., EVA resin) to thereby separate the first multilayer structure into the cover glass and the resin, e.g., EVA resin,
the separation step IV being a step in which the back sheet is removed from the third multilayer structure separated in the separation step II (comprising the glass substrate, the resin, e.g., EVA resin, and the back sheet) to thereby separate the third multilayer structure into the back sheet and a fourthmultilayer structure comprising the glass substrate and the resin, e.g., EVA resin, and
the separation step V being a step in which the resin, e.g., EVA resin, is removed from the fourth multilayer structure separated in the separation step IV (comprising the glass substrate and the resin, e.g., EVA resin) to thereby separate the fourth multilayer structure into the resin, e.g., EVA resin, and the glass substrate.

7. The method of CIS type thin-film photovoltaic module separation according to claim 6, wherein the separation step I comprises cutting that part of the CIS type thin-film photovoltaic module which corresponds to a peripheral part for the glass substrate with a cutting tool, e.g., a knife or cutter, from the back side to separate the module into the first multilayer structure (comprising the cover glass and the resin, e.g., EVA resin), which adjoins one side of the non-adhesive plastic resin, and the secondmultilayer structure (comprising the CIS type thin-film solar cell device, the glass substrate, the resin, e.g., EVA resin, and the back sheet).

8. The method of CIS type thin-film photovoltaic module separation according to claim 6, wherein the separation step II comprises removing the CIS type thin-film solar cell device from the second multilayer structure (comprising the CIS type thin-film solar cell device, the glass substrate, the resin, e.g., EVA resin, and the back sheet) by a dry mechanical method, e.g., sandblasting, scraping with a metallic blade, or a combination of these, to separate the secondmultilayer structure into the CIS type thin-film solar cell device and the third multilayer structure (comprising the glass substrate, the resin, e.g., EVA resin, and the back sheet).

9. The method of CIS type thin-film photovoltaic module separation according to claim 6, wherein the separation step III comprises removing the resin, e.g., EVA resin, from the first multilayer structure (comprising the cover glass and the resin, e. g. , EVA resin) by a dry mechanical method of removal, e.g., sandblasting, or a wet chemical method of removal, e.g., boiling, high-temperature steam blowing, or immersion in an acid, to separate the first multilayer structure into the resin, e.g., EVA resin, and the cover glass.

10. The method of CIS type thin-film photo voltaic module separation according to claim 6, wherein the separation step IV comprises removing the back sheet from the third multilayer structure (comprising the glass substrate, the resin, e.g., EVAresin, and the back sheet) by mechanical stripping to separate the third multilayer structure into the back sheet and the fourth multilayer structure (comprising the glass substrate and the resin, e.g., EVA resin).

11. The method of CIS type thin-filmphotovoltaicmodule separation according to claim 6, wherein that the separation step V comprises removing the resin, e.g., EVA resin, from the fourth multilayer structure (comprising the glass substrate and the resin, e.g., EVA resin) by a dry mechanical method, e.g., sandblasting, scraping with a metallic blade, or a combination of these, to separate the fourthmultilayer structure into the resin, e.g., EVA resin, and the glass substrate.
